# EUROPEAN PATENT SPECIFICATION

(11) **EP 1 377 981 B1**
(45) Date of publication and mention of the grant of the patent: **06.06.2007**
(21) Application number: 02726654.3
(22) Date of filing: 09.04.2002
(51) Int. Cl.: G11C 7/00, G11C 29/00, G01R 31/28

(54) **METHOD AND SYSTEM TO OPTIMIZE TEST COST AND DISABLE DEFECTS FOR SCAN AND BIST MEMORIES**
VERFAHREN UND SYSTEM ZUR OPTIMIERUNG DER TESTKOSTEN UND DEAKTIVIERUNGSDEFEKTE FÜR SCAN- UND BIST-SPEICHER
PROCEDE ET SYSTEME POUVANT OPTIMISER DES COUTS D'ESSAI ET DESACTIVER DES BLOCS DE MEMOIRE DE BALAYAGE OU DE MEMOIRE BIST DEFECTUEUX

(30) Priority: 10.04.2001 US 282917 P; 05.04.2002 US 116128
(43) Date of publication of application: 07.01.2004
(73) Proprietor: Syntest Technologies, Inc., Sunnyvale, CA 94086 (US)
(72) Inventor: WANG, Laung-Terng (L.-T.), Sunnyvale, CA 94087-2304 (US); LIN, Shyh-Horng, Taipei 112 (TW); WANG, Hsin-Po, Chu-Tung (TW); WEN, Xiaoqing, Sunnyvale, CA 94087-2304 (US); HSU, Chi-Chan, Hsinchu 310 (TW); VU, Anthony, M., Round Rock, TX 78681 (US); PARK, Yo Han, Austin, TX 78759 (US)
(74) Representative: Jones, Graham Henry
(86) International application number: PCT/US2002/008245
(87) International publication number: WO 2002/084668

(56) References cited:
- US-A- 5 535 164
- US-A- 5 617 531
- US-A- 5 825 785
- US-A- 5 875 153
- US-A- 5 878 051
- US-A- 5 974 579
- US-A- 5 995 731
- US-A- 6 001 662
- US-A- 6 014 336
- US-B1- 6 233 182
- US-B1- 6 347 056
- US-B1- 6 381 715
- US-B1- 6 393 504
- US-B2- 6 359 818
- NADEAU-DOSTIE B., SILBURT A., AGARWAL V.K.: 'A serial interfacing technique for built-in and external testing of embedded memories' PROCEEDINGS OF THE IEEE 1989, pages 22.2.2 - 22.2.5, XP000075571
- FRANKLIN M., SALUJA K.K.: 'Built-in self-testing of random-access memories' IEEE 1990, pages 45 - 56, XP000170952
- NORDHOLZ P., OTTERSTEDT J., NIGGEMEYER D.: 'A defect-tolerant word-oriented static RAM with built-in self-test and self-reconfiguration' IEEE 1996, pages 124 - 132, XP010199939
- NIGGEMEYER D., OTTERSTEDT J., REDEKER M.: 'A defect-tolerant DRAM employing a hierarchical redundancy scheme, built-in self-test and self-reconfiguration' IEEE 1997, pages 33 - 40, XP010244662

## Description

### RELATED APPLICATION DATA

This application claims the benefit of U.S. Provisional Application No. 60/282,917 filed April 10, 2001.

### TECHNICAL FIELD

The present invention generally relates to the field of memory design and test using design-for-test (DFT) techniques. Specifically, the present invention relates to the field of memory test and diagnosis for integrated circuits using built-in self-test (BIST) and memory scan techniques.

### BACKGROUND

A modern integrated circuit usually contains a significant number of embedded memory arrays: some are small and some are large. Generally, as much as half of the die size of an integrated circuit can be consumed by embedded memory arrays. In addition, a memory array usually has a very dense physical implementation due to its regular structure. As a result, memory arrays are prune to physical defects, making it important to thoroughly test all embedded memory arrays in an integrated circuit.

There are two approaches to testing an embedded memory array: external test and built-in self-test (BIST), as described below:

In external test, a direct access channel should be first established between an automatic test equipment (ATE) and the embedded memory array under test. Then, via the direct access channel, test patterns are applied to the embedded memory array from the ATE, and test responses are transferred back to the ATE from the embedded memory array under test. Comparison of the test responses with expected responses is conducted on the ATE to determine whether the embedded memory array is faulty or not. The direct access channel can be parallel or serial. With a parallel direct access channel, all of the data inputs, data outputs, address lines, and control lines of an embedded memory array can be accessed from an ATE at the same time. Since a large interface between an ATE and an embedded memory array is needed, a parallel direct access channel is usually very costly, making it not suitable for an integrated circuit with a significant number of embedded memory arrays. With a serial direct access channel, a small interface between an ATE and an embedded memory array is enough but test patterns and test responses need to be transferred in a serial manner. The typical implementation of a serial direct access channel is the memory scan test technique, in which one or more scan chains are placed around a memory array for shifting-in test patterns and shifting-out test responses. Note that the memory scan test technique still needs the involvement of an ATE during memory test.

In the memory BIST technique, all test patterns and control signals are generated and applied to the embedded memory array under test by some circuitry residing in the same integrated circuit as the embedded memory array. Comparison between test responses and expected responses is also conducted in the same integrated circuit. This test technique requires a simple interface between an integrated circuit and an ATE, which can be significantly simplified. The advantages of the memory BIST technique include lower test cost, higher test quality, and better test reusability.

The common practice now in the industry is testing large embedded memory arrays with the memory BIST technique while testing relatively small memory arrays, e.g. those with less than 4K bits, with the memory scan technique.

In memory test using either the memory BIST technique or the memory scan technique, there are three key issues: fault coverage, test scheduling, and memory repair, as described below:

First, a memory test technique should be able to detect or diagnose as many faults as possible. Especially, it is important to target coupling faults, which create dependency between two bits in a memory word, preventing them from changing their values independently. Since this type of faults is common in a modern memory array, a memory test technique should have a high coverage of coupling faults. In addition, since different memory test algorithms have different corresponding fault coverage, it is important that a memory test technique is flexible enough to adapt to different memory test algorithms.

Second, an integrated circuit usually contains a significant number of embedded memory arrays, some of them may be quite large. If all of the embedded memory arrays are tested or diagnosed at the same time, more power may be consumed than the package can allow, causing the test to fail or even damaging the package itself. To solve this problem, test scheduling is needed to properly order the test operations of individual memory arrays.

Third, even if a memory array is found faulty, it is costly to just throw it away since the rest of the integrated circuit, including such complex and expensive logic blocks as a MPU, may be able to operate correctly. In addition, it is quite possible that only a few memory cells in a large memory array are faulty. As a result, it is often necessary to repair a faulty or defective memory array by reconfiguring it in such a manner that any valid memory address is mapped onto a memory word consisting of only good or defect-free memory cells.

Prior-art solutions for the above three memory test issues include a solution for improving coupling fault coverage based on using the content of a Johnson counter as test data (prior-art solution #1), two solutions for memory test scheduling based on token passing or event triggering (prior-art solution #2 and prior-art solution #3), and a solution for memory repair using redundant word lines and bit lines (prior-art solution #4), as summarized below:

Prior-art solution #1 is described in U.S. Pat. No. 6,041,426 by Qureshi (2000). This solution is based on using a Johnson counter to generate data to be written into a memory array during memory test. The parity of the content of a Johnson counter is also written into a memory array as part of test data. When data is read out of a memory word, both the data itself and its parity are checked to see whether there is any mismatch. This solution, however, suffers from several disadvantages: First, this solution is not a pure Johnson counter based technique since it requires both data and its parity are checked. This Johnson counter plus parity approach needs more complex additional hardware at higher hardware overhead. Second, this solution is intended to be used only in the memory BIST technique. Applying this solution to a small embedded memory array will be too costly. Third, each test cycle in this solution includes a write operation followed by a read operation and then a compare operation. In addition, for each word, only two test cycles are applied. Since only one data from a Johnson counter is applied in each test cycle, only two data patterns from a Johnson counter are applied for each word. Obviously, there is no guarantee that all of the four 2-bit logic value combinations of 00, 01, 10, and 11 will be written into every two bits in every memory word; as a result, some coupling faults may not get detected or diagnosed. Fourth, the BIST control scheme in this solution is not flexible in that it cannot be easily adapted to implement other memory test algorithms. This limits the usefulness of the solution since the yield and other characteristics of different fabrication processes may require different memory test algorithms to be used.

Prior-art solution #2 is described in U.S. Pat. No. 6,237,123 by Kim, et al. (2001). This solution is to implement a test scheduling scheme by ordering and controlling memory BIST operations for multiple BISTed memory arrays. It uses a token passing network, called a universal BIST scheduler (USB), to schedule BISTed memory arrays in order to implement parallel BIST operations, serial BIST operations, or a mixture of both. This solution, however, suffers from several disadvantages: First, a token passing network is large and incurs considerable hardware overhead. Second, a token passing network, which involves the use of finite-state machines, is complex in functionality. This increases the possibility that the token passing network itself suffers from some sort of faults. Third, no mechanism is provided to check whether a token passing network can operate correctly. Fourth, setting up a universal BIST schedule with a token passing network might involve a relatively large volume of data.

Prior-art solution #3 is described in U.S. Pat. No. 5,995,731 by Crouch, et al. (1999). This solution is to integrate multiple memory BIST controllers for testing multiple embedded memory arrays. Basically, it uses one AND gate and one OR gate to combine DONE signals and FAIL signals from a group of memory arrays determined to be tested in parallel. The output of the AND gate can then be used as an event triggering signal to start the memory BIST test session for the next group of memory arrays. This helps in testing two groups of memory arrays in serial mode but testing all memory arrays in each group in parallel mode. In addition, in order to output the bitmap of each memory array in a memory group, a multiplexer is added and all memory arrays in the memory group will share the output of the multiplexer in diagnosis mode. This solution is intended as a low overhead memory BIST scheduling technique. This solution, however, suffers from several disadvantages: First, this solution is not flexible in that the test scheduling result, including the memory grouping result and the test order among the memory groups, is implemented as part of an integrated circuit, making it impossible to change once the integrated circuit is fabricated. Second, if the memory arrays in a memory group are physically scattered from each other, then combining DONE signals and FAIL signals may be difficult due to routing congestion. Third, this solution makes it difficult to diagnose an individual memory array since there is no way to activate only one memory array but disable all other memory arrays in a memory group. Suppose, for example, that a memory group contains three memory arrays. If the combined FAIL signals of this memory group indicate a failure, there is no way to know which memory array failed. In order to identify the failed memory array, the bitmaps for all of the three memory arrays have to be obtained. For this purpose, the memory BIST operation has to be repeated three times for the memory group since the bitmaps for the three memory arrays have to share one output pin via a multiplexer. This makes the solution very time-consuming in fault diagnosis.

Prior-art solution #4 is described in U.S. Pat. No. 6,343,366 by Okitaka (2002). This solution is to repair a memory array when it is found to be faulty. For this purpose, the faulty memory cell should be first identified. Then, the faulty memory cell is replaced with a spare or redundancy memory cell that is placed in the memory array in advance. This solution, however, suffers from several disadvantages: First, this memory repair solution is very costly since it needs complex repair circuitry. Second, this memory repair solution only succeeds when there are enough redundancy memory cells embedded in a memory array. Since there are only a limited number of redundancy memory cells, such a memory repair becomes impossible if there are too many faulty memory cells. Third, this memory repair solution targets individual faulty memory cells. In reality, it is highly possible that multiple memory cells in the same physical neighborhood may become defective at the same time. Repairing those memory cells one by one is not only inefficient but also incurs high hardware overhead.

U.S. Pat. No. 6001662 discloses a method for providing a self-test controller where Johnson counter is generating data to be written in a memory array during memory test.

Therefore, there is a need for an improved memory test technique, comprising a method, apparatus, and a computer-aided design (CAD) system, to achieve high coupling fault coverage, flexible test scheduling, and efficient memory repair capability. This memory test technique should have low hardware overhead, can be used in both memory BIST and memory scan techniques, can detect or diagnose any coupling fault between any two bits in any memory word, and can be easily adapted to any memory test algorithm (refer to prior-art solution #1). In addition, this memory test technique should have a flexible, low-overhead, and simple test scheduling scheme (refer to prior-art solution #2 and prior-art solution #3). Furthermore, this memory test technique should have a simple and efficient memory repair solution that is not limited by the number of redundancy rows and columns (refer to prior-art solution #4). Finally, this memory test technique should have powerful diagnosis capability, which is not fully addressed by prior-art solutions.

### SUMMARY

The invention is defined by claim 1. Accordingly, a primary objective of the present invention is to provide an improved memory test system for both memory BIST and memory scan techniques. This memory test system comprises a method and apparatus for allowing detection and location of any coupling fault between any two bits in any memory word in an embedded memory array, allowing flexible test scheduling, and allowing efficient memory repair. The present invention further comprises a computer-aided design (CAD) system that synthesizes such a memory test system and generates desired HDL (hardware description language) test benches. The memory test technique specified in the present invention is summarized as follows:

### (1) Data Generation Based on a Sequence Generator

During memory test, specially designed data need to be written into a memory array. The type of data written into a memory array is an important factor determining the fault coverage of the memory test.

It has been shown that the coupling fault model is a common defect mode in modern memory arrays. This type of fault manifests itself by creating dependency between two bits in a memory word. In order to detect or diagnose a coupling fault, it is necessary to write different values to the two bits and then read the values back to see whether they are correctly written. In order to detect or diagnose any coupling fault between any two bits in any memory word, the data written into any memory word should apply different values to any two bits. It is thus clear that, one can use a sequence generator to generate a sequence of patterns where any two bits in the sequence of patterns contain 4 distinct states: 00, 01, 10, and 11. If this sequence of patterns is written to a memory array, it is obvious that any coupling fault between any two bits in any word in a memory array can be detected or diagnosed.

An n-stage Johnson counter, also called a twisted-ring counter, is a synchronous counter composed of n D flip-flops and a very small combinational logic network. An n-stage Johnson counter has the following characteristic: If initialized with a I-out-of-n code, an n-stage Johnson counter will count through 2n states so that the outputs of any two D flip-flops in the Johnson counter experience all 2-bit logic value combinations: 00, 01, 10, and 11. As a result, a Johnson counter can be used as a sequence generator to generate a sequence of patterns to be written into a memory array during memory test in order to detect or diagnose any coupling fault between any two bits in any word in a memory array.

For example, if each memory word in a memory array is n-bit wide, then an n-stage Johnson counter can be used to generate data to be written into each word of the memory array during memory test. By writing the content of a Johnson counter into a memory word and then reading it back for comparison, it can be easily determined whether there is a coupling fault between any two bits in the memory word.

The present invention comprises any method and apparatus that use a sequence generator to generate data to be written into a memory array during memory test. Such a sequence should be able to generate a sequence of patterns where any two bits in the sequence of patterns contain 4 distinct states: 00, 01, 10, and 11. As one embodiment of the present invention, a Johnson counter can be used as such a. sequence generator. Besides, a data connector, composed of a plurality of multiplexers, are added to connect the outputs of a sequence generator to the data inputs of a memory array in order to write data from the sequence generator into the memory array during memory test. In addition, a sequence generator is reconfigured by adding one multiplexer to the input of its first-stage D flip-flop so that the sequence generator can operate as a shift register. This is used to initialize a sequence generator to a specific initial state, usually a 1-out-of-n code, through boundary-scan. Furthermore, additional hold-state circuitry is added to make a sequence generator keep its state unchanged even when its clock is activated. This feature is useful in designing a memory BIST (built-in self-test) controller. In the present invention, a sequence generator enhanced with a data connector, shift circuitry, and hold-state circuitry is used as a data generator. The benefit of such a data generator is that any coupling fault between any two bits in any memory word can be detected or diagnosed at low area overhead.

### (2) Address Re-Mapping

If a memory array embedded in an integrated circuit is found defective through memory test, memory repair is usually considered instead of just discarding the integrated circuit. For this purpose, the memory array must contain enough redundancy including spare columns and/or rows. When a memory array is found to have faults, it will be determined whether the faults are repairable by switching some columns and/or rows to spare ones. However, since the number of spare columns and/or rows is limited, a memory array is not always repairable if it contains too many faults.

A memory array is usually organized into a set of smaller building blocks called memory banks. The address of such a memory array has two portions: one is used to indicate the memory bank, and the other is used to indicate the offset in the memory bank. As a result, mapping an address to a word in a memory array can be conducted by first decoding the memory bank portion of the address to a memory bank and then using the offset portion of the address to locate the corresponding word in the memory bank directly. Obviously, by changing the memory bank decoding function, one address can be mapped onto different physical locations in a memory array.

The present invention further comprises any method and apparatus that use an address re-mapping logic block to alternate the original memory bank decoding function in order to skip all defective memory banks. The address space of the re-mapped memory banks, though smaller than that of original memory banks, also starts from 0 and increases in a continuous manner. The address re-mapping function can be implemented with an embedded programmable element, including a programmable ROM (PROM), a programmable logic device (PLD), a programmable logic array (PLA), a field programmable gate array (FPGA), or a flash memory. The benefit of this re-mapping technique is that it can extend the life of a memory array at a low cost. In addition, this re-mapping technique is flexible in that a re-mapping function can be easily changed. This makes it possible to repair an embedded memory array in an integrated circuit by address re-mapping even when the integrated circuit is used in a system.

Suppose, for example, that a memory array has four memory banks: B0, B1, B3, and B4. Any address for this memory array should have two bits, A0 and A1, which are used to indicate which memory bank should be selected. Suppose that, the original memory bank mapping function is as follows:

| A1 | A0 | Selected Memory Bank |
|---|---|---|
| 0 | 0 | B0 |
| 0 | 1 | B1 |
| 1 | 0 | B2 |
| 1 | 1 | B3 |

Assume that memory bank B1 is found defective during memory test. In order to use this memory array in a reduced-size manner, an address re-mapping function can be used to re-map the memory bank address {A1=0, AO=1} from memory bank B1. to memory bank B3. The result is shown below:

| A1 | A0 | Selected Memory Bank |
|---|---|---|
| 0 | 0 | B0 |
| 0 | 1 | B3 |
| 1 | 0 | B2 |

### (3) Flexible Memory Test Scheduling Scheme Based on Memory Selectors

An integrated circuit may contain a large number of embedded memory arrays. In functional mode, the embedded memory arrays are usually not intended to be operated at the same time. In test mode, however, it is possible to operate any number of embedded memory arrays in an integrated circuit at the same time. This creates the risk of violating the power consumption limit of the integrated circuit. In a modern integrated circuit, embedded memory arrays usually take up larger area than logic blocks. As a result, power management during memory test is very important.

The present invention further comprises any method and apparatus that use a flexible memory test scheduling scheme, in which one storage element, called a memory selector, is added to each memory array. The value of a memory selector indicates whether the corresponding memory array is to be tested or diagnosed during a memory test session. If the logic value is 1, the corresponding memory array will be tested or diagnosed; otherwise, the corresponding memory array will be made inactive to order to consume little power, while other memory arrays are tested or diagnosed. In addition, a group of memory arrays may share one memory selector if the memory arrays are to be tested or diagnosed in parallel all the time. Furthermore, all memory selectors in an integrated circuit can be put into one memory selection shift register that can be accessed from the outside of the integrated circuit through boundary-scan. Memory test scheduling information, in terms of a set of logic values for all memory selectors, can be shifted into the memory selection register before memory test is started. After that, a single memory test start signal can be issued. The memory arrays that are actually tested or diagnosed are determined by the content of the memory selection register. The benefit of this memory test scheduling scheme based on memory selectors is its flexibility. Any memory test order can be achieved by using this scheme. In addition, there is no need to fix a test order before production. Furthermore, it is easy to select only one memory array for the diagnosis purpose.

### (4) Adaptable Memory BIST Controller

BIST (built-in self-test) is a test scheme in which test stimuli are generated in an integrated circuit and applied to a part of the integrated circuit under test. Test responses from the part of the integrated circuit are also analyzed in the integrated circuit to determine whether there is any fault. The benefits of BIST includes less test interface requirement, less tester involvement, less costs for test generation and application, higher test quality due to at-speed test, and better test reuse. Especially, for a regularly-structured circuit such as a memory array, its test patterns are so regular that they can be easily generated by using well-established March algorithms. Therefore, it is suitable to implement additional circuitry to generate the test patterns in an integrated circuit, especially for memory arrays. As a result, memory BIST is now a common test practice. A memory BIST circuitry usually consists of a data generator, an address generator, a comparator, a finite-state machine for generating all necessary control signals, and some additional logic circuitry that is used to switch data inputs, address inputs, and control inputs from functional mode to memory BIST mode.

The present invention further comprises any method and apparatus that use a memory BIST controller which applies a sequence of patterns where any two bits in the sequence of patterns contain 4 distinct states: 00, 01, 10, and 11. Such a sequence of patterns can be generated by a sequence generator such as a Johnson counter, and it can guarantee that any coupling fault between any two bits in any word in the embedded memory array can be detected or diagnosed. In addition, the memory BIST controller should be able to be adapted to any bit-wise March-type memory self-test algorithm. That is, a bit-wise March-type memory self-test algorithm can be specified in a text format, and a computer-aided design (CAD) system can be used to generate a memory BIST controller implementing the bit-wise memory test algorithm. The benefit is its flexibility of meeting various test requirements by adapting to any March-type memory test algorithm. In addition, each memory array also contains a memory selector, a BIST result chain, and a BIST debug chain. A BIST result chain is a shift register composed of D flip-flops representing such BIST results as Finish and Pass/Fail. A BIST debug chain is a shift register composed of D flop-flops representing such BIST debug information as Error, Error Data, and Error Address. In addition, a scan connector can be used to connect memory selectors, BIST result chains, and BIST debug chains together in an integrated circuit with multiple embedded memory arrays, making them accessible through boundary-scan. The connection can be serial or parallel. This scan chain is useful in fault diagnosis.

An example memory BIST controller, in accordance with the present invention, is described below:
Assume that an 8-by-4 memory array (8 words and each word with 4 bits) is to be tested or diagnosed by the March algorithm. This is an O(5N) memory test algorithm, where N is the number of words in a memory array. O(5N) means the test time based on the March algorithm is proportional to 5N. If this memory test algorithm is used, the memory BIST controller, in accordance with the present invention, will operate in the following manner:
(a) Set the corresponding memory selector to logic value 1, enabling the memory array to be tested or diagnosed.
(b) Initialize the data generator to an all-0 state.
(c) Write initial data to all words in the memory array.
(d) For each word in an upward order, repeat the following operations for 4 times:
   (i) Read out the contents of the currently addressed word and compare the memory contents with the contents of the data generator to determine whether there is a fault.
   (ii) Shift the data generator by one bit.
   (iii) Write the contents of the data generator to the currently addressed word.
(e) For each word in a downward order, repeat step (d).

### (5) Adaptable Memory Scan Controller

Despite all the advantages of memory BIST, its . overhead might become an issue in some cases, especially for a small memory array. In order to solve this problem, a memory scan technique can be used, in which scan cells are inserted at data inputs, data outputs, and address lines of a memory array. These scan cells can be connected into one or more scan chains. Through the scan chains, data and addresses can be provided from an ATE (automatic test equipment) to the memory array, and test responses can be transferred from the memory array to the ATE. By moving test generation, test application, and test response comparison to an ATE, the memory scan technique can achieve memory test at very low hardware overhead. As a result, this memory test technique is suitable for testing small memories.

The present invention further comprises any method and apparatus that use a memory scan controller which applies a sequence of patterns where any two bits in the sequence of patterns contain 4 distinct states: 00, 01, 10, and 11. Such a sequence of patterns can be generated by a sequence generator such as a Johnson counter in an ATE. The benefit is that any coupling fault between any two bits in any memory word in the embedded memory array can be detected or diagnosed. In addition, the hardware overhead of such a memory scan technique is low, making it suitable for smaller memory arrays. Furthermore, the memory scan controller should be able to be adapted to any bit-wise March-type memory scan-test algorithm. Note that such a memory scan controller usually resides in an ATE. Furthermore, the scan cells inserted at the data inputs and the address lines of a memory array are put into an input scan chain (ISC); while the scan cells at the data outputs of the memory array are put into an output scan chain (OSC). These two scan chains are connected together into a scan status chain, which can be made accessible through boundary-scan.

An example memory scan controller, in accordance with the present invention, is described below:

Assume that an 8-by-4 memory array (8 words and each word with 4 bits) is to be tested or diagnosed by the March algorithm. This is an O(5N) memory test algorithm, where N is the number of words in a memory array. O(5N) means the test time based on the March algorithm is proportional to 5N. If this memory test algorithm is used, the memory scan controller, in accordance with the present invention, will operate in the following manner:
(a) Set the corresponding memory selector to logic value 1, enabling the memory array to be tested or diagnosed.
(b) Initialize the data generator to an all-0 state.
(c) Shift in initial data and write to all words in the memory array.
(d) For each word in an upward order, repeat the following operations for 4 times:
   (i) Read out the contents of the currently addressed word, shift out the contents via the memory scan chain, at the same time shift in new data to be written into the memory array via the memory scan chain, and compare the memory contents with expected results to determine whether there is a fault.
   (ii) Write the newly shifted-in data into the currently addressed word.
(e) For each word in a downward order, repeat step (d).

To summarize, the present invention uses an improved memory test technique. A sequence generator is used to generate a sequence of patterns where any two bits in the sequence of patterns contain 4 distinct states: 00, 01, 10, and 11. By writing such a sequence of patterns into a memory array, it can be guaranteed that any coupling fault between any two bits in any memory word in the embedded memory array can be detected or diagnosed. A Johnson counter can be used as such a sequence generator. Basically, by writing 2n different contents from a Johnson counter to each memory word, it can be guaranteed that any coupling fault between any two bits in any memory word in the embedded memory array can be detected or diagnosed. Here, n is the width of a memory word. The hardware overhead needed to implement a Johnson counter is low. Besides, adaptable memory test controllers are used in memory BIST mode and in memory scan mode, making it easy to meet various test requirements by adapting to any bit-wise March-type memory self-test or scan-test algorithm. In addition, flexible test scheduling scheme is used, which is based on the use of memory selectors. Each embedded memory array has its own memory selector to indicate whether the memory array is to be tested or not. All the memory selectors are put into a scan chain, through which different test schedules can be easily realized. This scheme also makes it easy to diagnose any individual embedded memory array. Furthermore, a memory repair scheme based on address re-mapping logic block is used, which can skip any defective memory banks. This will extend the life of an embedded memory array at a reduced memory size. The address re-mapping logic block is programmable, making it possible to rescue an embedded memory array in an integrated circuit even when the integrated circuit is used in a system. Finally, a diagnosis scheme is used to efficiently bring BIST results and BIST debug information to the outside through boundary-scan. This greatly improves the diagnosability of an integrated circuit with a significant number of embedded memory arrays.

### BRIEF DESCRIPTION OF THE DRAWINGS

The above and other objects, advantages and features of the invention will become more apparent when considered with the following specification and accompanying drawings wherein:
FIG. 1 shows an example memory BIST controller to test or diagnose an 8-by-4 memory in accordance with the present invention;
FIG. 2 shows an example data generator including a 4-stage sequence generator in accordance with the present invention;
FIG. 3 shows an example sequence of patterns generated by the 4-stage sequence generator of FIG. 2 in accordance with the present invention;
FIG. 4 shows an example address generator including an address re-mapping logic to disable all defective memory banks and re-map all good memory banks onto a reduced-size memory in accordance with the present invention;
FIG. 5 shows an example memory selector comprising 2 D flip-flops to test or diagnose two memories using memory BIST in accordance with the present invention;
FIG. 6 shows an example BIST status chain comprising a BIST result chain and a BIST debug chain in accordance with the present invention;
FIG. 7 shows a first example scan connector in a hierarchical memory BIST controller to test or diagnose a plurality of memories using two memory BIST controllers;
FIG. 8 shows a second example scan connector in a hierarchical memory BIST controller to test or diagnose a plurality of memories using two memory BIST controllers;
FIG. 9 shows a prior-art O(5N) March test procedure and an O(5N) adapted bit-wise March test procedure of one embodiment of the present invention using memory BIST to test or diagnose the memory of FIG. 1;
FIG. 10 shows an example memory scan controller to test or diagnose an 8-by-4 memory in accordance with the present invention;
FIG. 11 shows an example scan status chain comprising the input scan chain and output scan chain in accordance with the present invention;
FIG. 12 shows two example scan connectors in a hierarchical memory scan controller to test or diagnose a plurality of memories using two memory scan controllers;
FIG. 13 shows a prior-art O(5N) March test procedure and an O(5N) adapted bit-wise March test procedure of one embodiment of the present invention using memory scan to test or diagnose the memory of FIG. 10;
FIG. 14 shows a flow diagram of a computer-aided design (CAD) system for synthesizing a hierarchical memory BIST controller in accordance with the present invention;
FIG. 15 shows a flow diagram of a memory BIST method to test or diagnose a plurality of memories in accordance with the present invention;
FIG. 16 shows a flow diagram of a computer-aided design (CAD) system for synthesizing a hierarchical memory scan controller in accordance with the present invention;
FIG. 17 shows a flow diagram of a memory scan method to test or diagnose a plurality of memories in accordance with the present invention; and
FIG. 18 shows an example system in which a computer-aided design (CAD) system to test or diagnose a plurality of memories, in accordance with the present invention, may be implemented.

### DETAILED DESCRIPTION OF THE INVENTION

The following description is presently contemplated as the best mode of carrying out the present invention. This description is not to be taken in a limiting sense but is made merely for the purpose of describing the principles of the invention. The scope of the invention should be determined by referring to the appended claims.

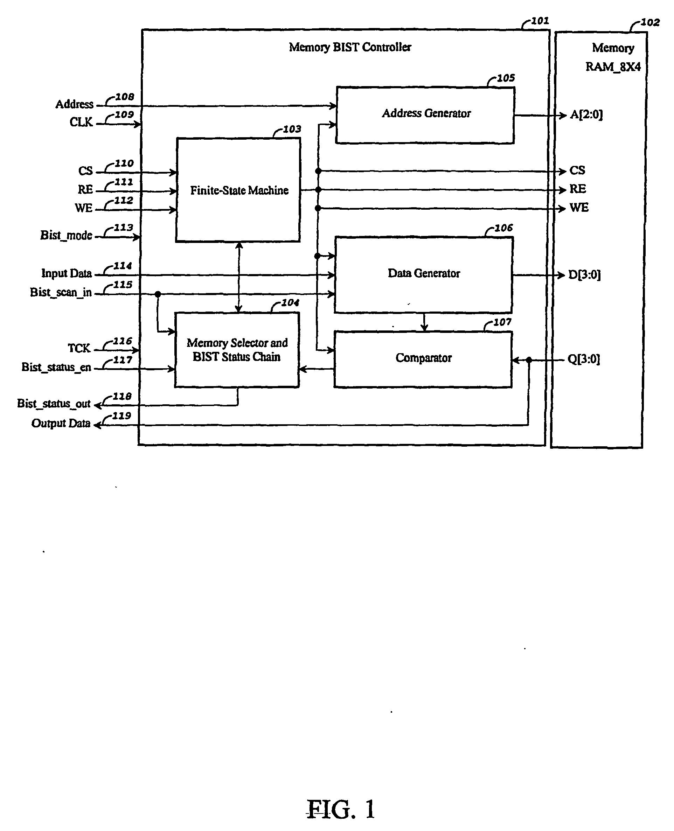

FIG. 1 shows an example memory BIST controller to test or diagnose an 8-by-4 memory in accordance with the present invention. The memory BIST controller 101 comprises a finite-state machine 103, a memory selector and BIST status chain 104, an address generator 105, a data generator 106, and a comparator 107. The finite-state machine 103 controls the BIST operation for the memory RAM_8X4 102. When the memory selector 104 is set to logic value 1, the finite-state machine 103 will conduct the BIST operation on the memory RAM_8X4 102 by controlling the address generator 105, the data generator 106, and the comparator 107. Upon completion of the BIST operation or when an error is found, the signal values stored in the BIST status chain 104 can be shifted out through Bist_status_out 118 for memory diagnosis when required. The CLK signal 109 is supplied by the designer to be used as the BIST clock. The Bist_mode signal 113 is the signal to start the BIST operation. The Bist_scan_in signal 115 can be used as the common scan input of the memory selector and BIST status chain 104, and the data generator 106. The Bist_status_en signal 117 is the enable signal to shift the memory selector and BIST status chain 104. The normal address lines 108 go into the address generator 105. In functional mode, normal address lines will be connected to the address inputs of the memory RAM_8X4 102. The normal data inputs 114 go into the data generator 106. In functional mode, normal data inputs will be connected to the data inputs of the memory RAM_8X4 102. The normal CS 110, the normal RE 111, and the normal WE 112 are the chip select signal, the read control signal, and the write control signal of the memory RAM_8X4 102, respectively.

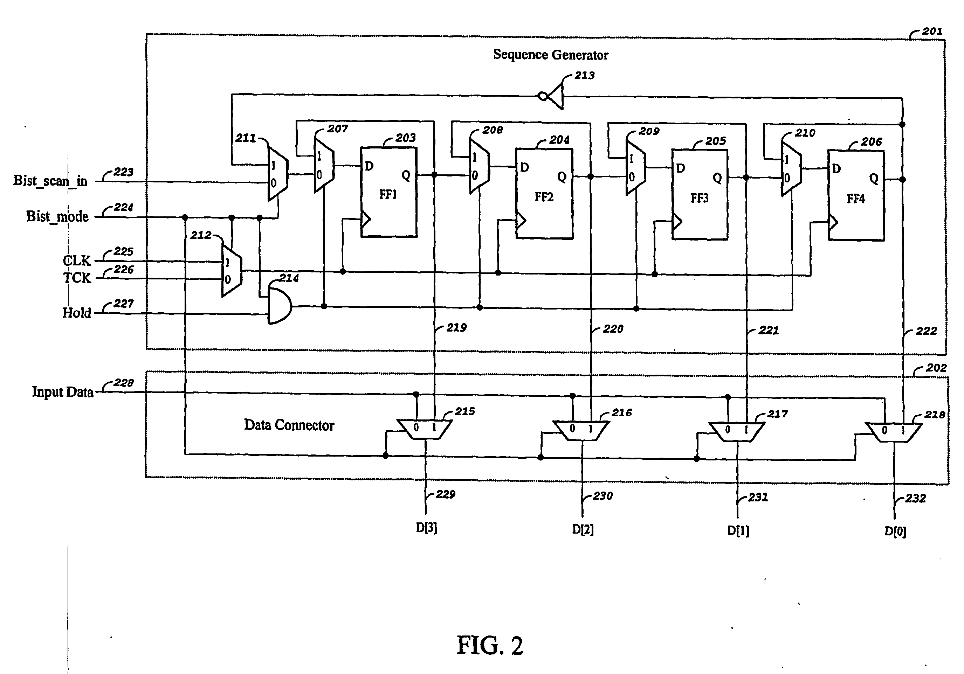

FIG. 2 shows an example data generator including a 4-stage sequence generator in accordance with the present invention.

The 4-stage sequence generator 201 is based on a Johnson counter. It consists of 4 D flip-flops: FF1 203 to FF4 206, 6 multiplexers 207 to 212, one AND gate 214, and one inverter 213. When the Bist_mode signal 224 is set to logic value 0, the sequence generator 201 will act as a shift register. As a result, required initial values can be shifted into the sequence generator 201 before the BIST operation is started. When the Bist_mode signal 224 is set to logic value 1 and the Hold signal 227 is set to logic value 0, the sequence generator 201 will act as a Johnson counter. As a result, test data to be written into a memory array can be generated. When both the Bist_mode signal 224 and the Hold signal 227 are set to logic value 1, the sequence generator 201 will hold its content unchanged even when the D flip-flops FF1 203 to FF4 206 are triggered.

In addition, a data connector 202 is used to connect the outputs of the sequence generator 201 and normal data inputs 228 to the data inputs D[3] 229 to D[0] 232 of a memory array. If the Bist_mode signal 224 is set to logic value 0, normal data inputs 228 will be applied to the data inputs D[3] 229 to D[0] 232 of a memory array. If the Bist_mode signal 224 is set to logic value 1, the outputs 219 to 222 of the sequence generator will be applied to the data inputs D[3] 229 to D[0] 232 of a memory array.

Furthermore, the multiplexer 213 uses the Bist mode signal 224 to determine the clock used to drive the sequence generator 201. If the Bist_mode 224 is set to logic value 0, the sequence generator uses TCK 226. If the Bist_mode signal 224 is set to logic value 1, the sequence generator uses CLK 225.

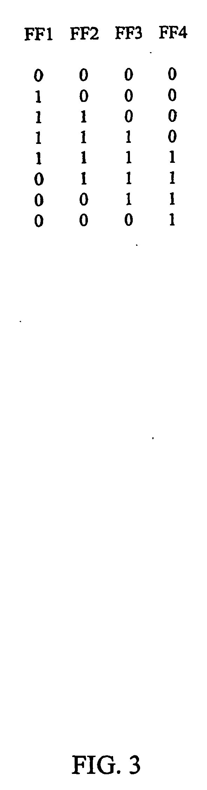

FIG. 3 shows an example sequence of patterns generated by the 4-stage sequence generator of FIG. 2 in accordance with the present invention.

The sequence of patterns 300 is generated by first initializing the 4-stage sequence generator 201 shown in FIG. 2 with an all-0 pattern and then applying 8 clock pulses. Obviously, any 2-bit logic value combination in {00, 01, 10, 11} appears at the outputs of any two D flip-flops FF1 203 to FF4 206 shown in FIG. 2. This means that, if this sequence of patterns is written into a memory word of 4-bit width as test data, any coupling fault between any two bits in any word will be detected.

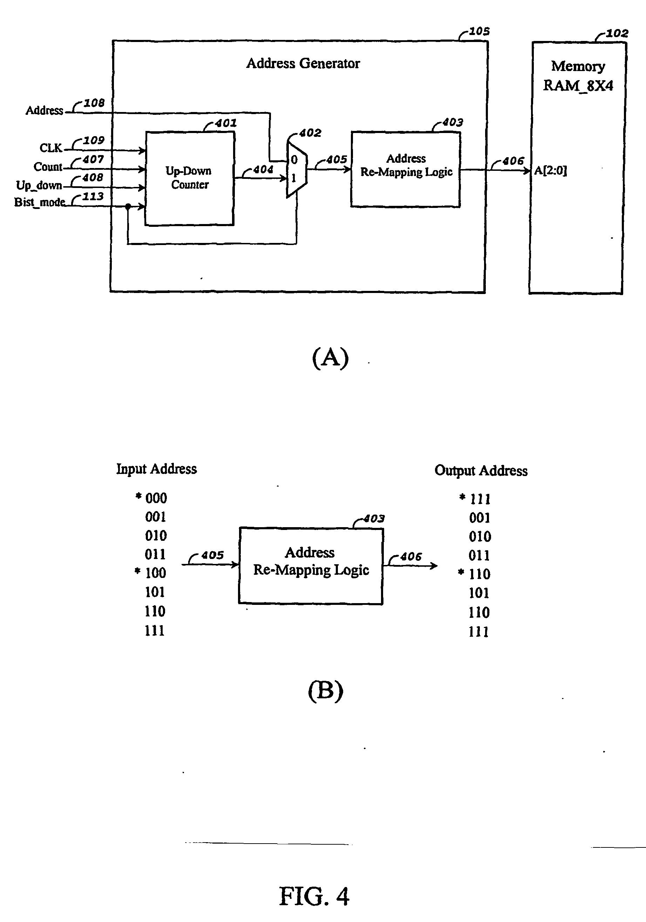

FIG. 4 shows an example address generator including an address mapping logic to disable all defective memory banks and re-map all good memory banks onto a reduced-size memory in accordance with the present invention.

FIG. 4A shows the structure of an address generator 105, which comprises an up-down counter 401, a multiplexer 402, and an address re-mapping logic 403. The Bist_mode signal 113 is used to initialize the up-down counter 401 and the select signal of the multiplexer 402. If the Bist_mode signal 113 is set to logic value 0, the output of the multiplexer 402 will be from the normal address 108. If the Bist_mode signal 113 is set to logic value 1, the output of the multiplexer 402 will be from the output 404 of the up-down counter 401. If the Count signal 407 is set to logic value 1, the up-down counter 401 will conduct the count operation; otherwise, the up-down counter 401 will hold its state. If the Up down signal 408 is set to logic value 1, the up-down counter 401 will count up; otherwise, the up-down counter 401 will count down. The address re-mapping logic 403 takes the output 405 of the multiplexer 402 and then maps it to a user specified value.

FIG. 4B shows an example of address re-mapping. As indicated on the input address side, bank addresses 000 and 100 correspond to two faulty memory banks. Through the address re-mapping logic 403, bank addresses 000 and 100 are mapped to bank addresses 111 and 110, respectively. Note that the effective bank address space is now reduced from a range of 000 to 111 to a range of 000 to 101.

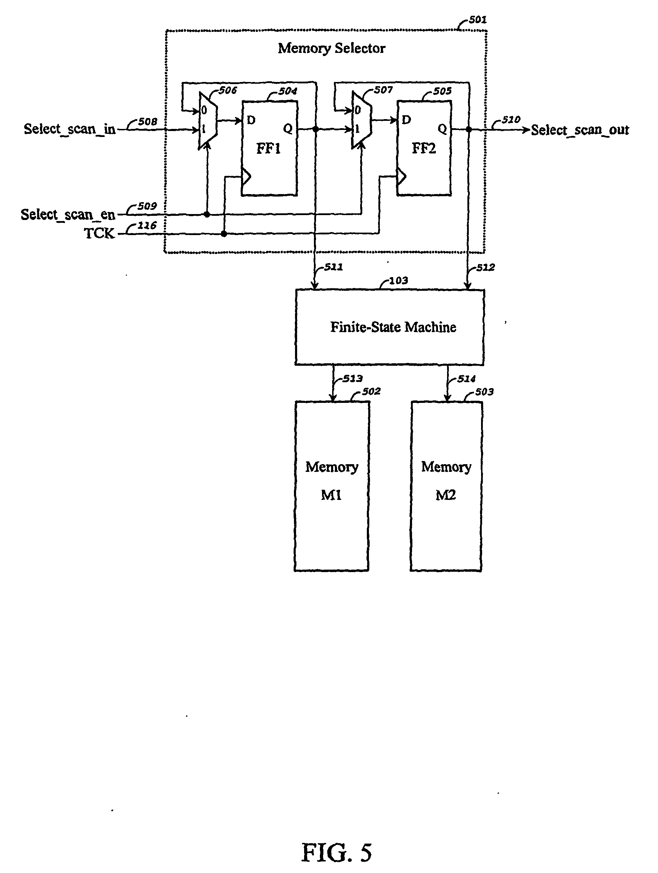

FIG. 5 shows an example memory selector comprising 2 D flip-flops to test or diagnose two memories using memory BIST in accordance with the present invention.

FIG. 5 shows an example memory selector 501 to test two memory arrays M1 502 and M2 503 in accordance with the present invention. The memory selector 501 comprises two D flip-flops FF1 504 and FF2 505, which form a shift register. Select_scan_in 508 is the input of the shift register. The Select_scan_en signal 509 is the enable signal of the shift register. The finite-state machine 103 accepts the outputs 511 and 512 of the memory selector 501 and generates the memory control signals 513 and 514 to enable or disable the memory arrays M1 502 and M2 503. When both FF1 504 and FF2 505 are set to logic value 1, the BIST operation is performed on both memory arrays M1 502 and M2 503. When FF1 504 and FF2 505 are set to logic value 1 and logic value 0, respectively, the BIST operation is only performed on the first memory M1 502. When FF1 504 and FF2 505 are set to logic value 0 and logic value 1, respectively, the BIST operation is only performed on the second memory M2 503. When both FF1 504 and FF2 505 are set to logic value 0, no BIST operation is performed on memory arrays M1 502 and M2 503. Select -scan-out 510 can be omitted if there is no other chain to be connected after the memory selector 501.

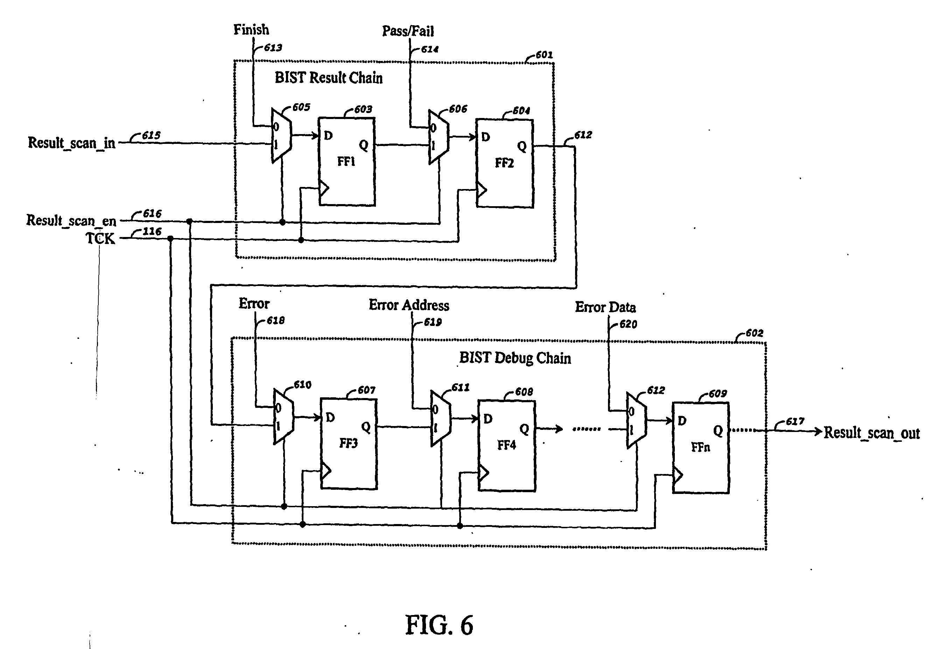

FIG. 6 shows an example BIST status chain comprising a BIST result chain and a BIST debug chain in accordance with the present invention.

The BIST result chain 601 comprises two D flip-flops FF1 603 and FF2 604. The Finish signal 613 comes from the finite-state machine 103 of the memory BIST controller 101 and is used to indicate whether the BIST operation finishes. The Pass/Fail signal 614 indicates the result of testing a memory array RAM_8X4 102. Generally, each memory array under test will have one Pass/Fail signal. The Result_scan_en signal 616, the Result_scan_in signal 615, and the Result_scan_out signal 617 are the enable signal, the input, and the output of the BIST result chain 601 and the BIST debug chain 602. This BIST result chain 601 can be independent or part of other chains.

The BIST debug chain 602 comprises a plurality of D flip-flops FF3 607 to FFn 609. The Error signal 618 comes from the finite-state machine 103 of the memory BIST controller 101 and is used to indicate whether an error is found. The Error Address signal 619 indicates that a faulty address is found. The Error Data signal 620 indicates that a faulty data is found. This BIST debug chain 602 can be independent or part of other chains.

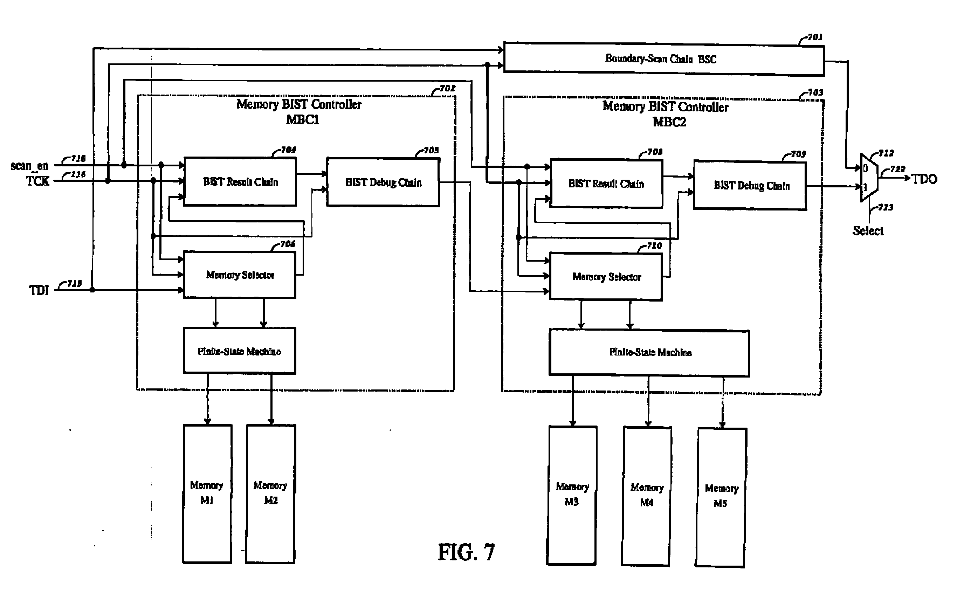

FIG. 7 shows a first example scan connector in a hierarchical memory BIST controller to test or diagnose a plurality of memories using two memory BIST controllers.

This example shows two memory BIST controllers MBC1 702 and MBC2 703, whose scan chains are connected to the boundary scan through the TDI 719 and TDO 722. The scan chains of the memory BIST controllers MBC1 702 and MBC2 703 share the TDO 722 with the boundary scan chain BSC 701. The multiplexer 712 uses the Select signal 723 to select the source for the TDO 722 output. The memory selector 706, the BIST result chain 704, and the BIST debug chain 705 in the memory BIST controller MBC1 702, and the memory selector 710, the BIST result chain 708, and the BIST debug chain 709 in the memory BIST controller MBC2 703 are connected into a single scan chain. The scan_en signal 718 is the enable signal of the scan chain. TCK 116 is used as the clock used to drive the scan chain and the boundary-scan chain BSC 701. The TDI 719 input is the common scan input of all chains.

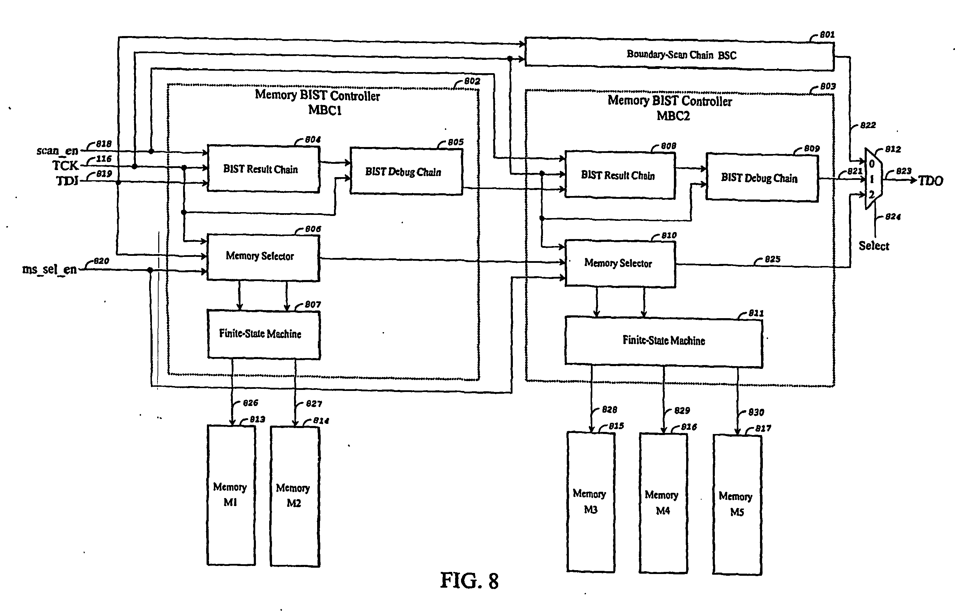

FIG. 8 shows a second example scan connector in a hierarchical memory BIST controller to test or diagnose a plurality of memories using two memory BIST controllers.

This example shows two memory BIST controllers MBC1 802 and MBC2 803, whose scan chains are connected to the boundary scan through the TDI 819 and TDO 823. The scan chains of the memory BIST controllers MBC1 802 and MBC2 803 share the TDO 823 with the boundary scan chain BSC 801. The multiplexer 812 uses the Select signal 824 to select the source for the TDO 823 output. The BIST result chain 804 and the BIST debug chain 805 in the memory BIST controller MBCl 802 and the BIST result chain 808 and the BIST debug chain 809 in the memory BIST controller MBC2 803 are connected into a single scan chain. The scan_en signal 818 is the scan enable signal of this scan chain. The memory selector 806 in the memory BIST controller MBC1 802 and the memory selector 810 in the memory BIST controller MBC2 803 are connected into another scan chain. The ms_sel_en signal 820 is the scan enable signal of this scan chain. The TCK 116 is used as the clock used to drive these two scan chains and the boundary-scan chain BSC 801. The TDI 819 input is the common scan input of all chains.

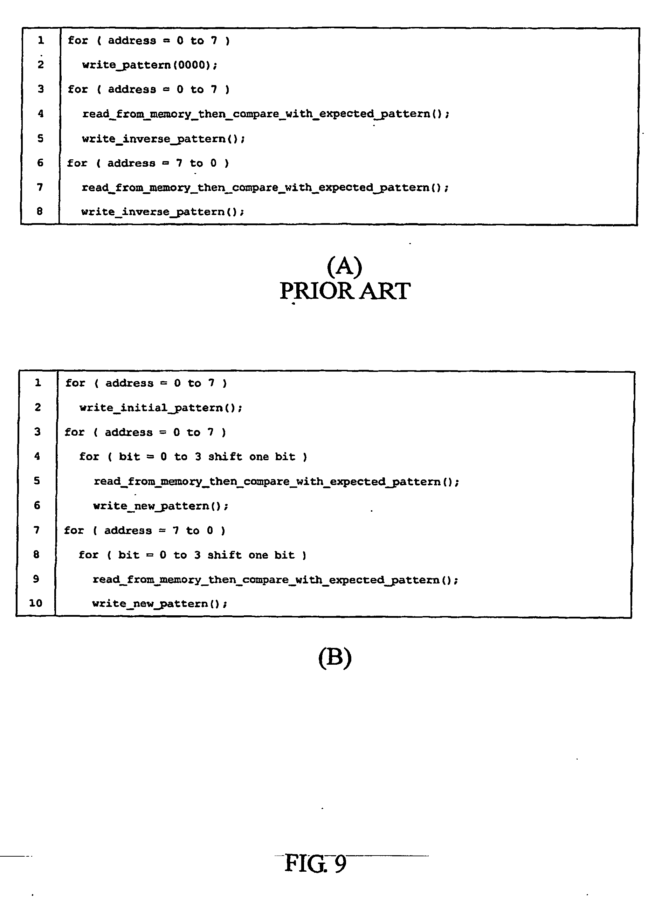

FIG. 9 shows a prior-art O(5N) March test procedure and an O(5N) adapted bit-wise March test procedure of one embodiment of the present invention using memory BIST to test or diagnose the memory of FIG. 1.

FIG. 9A shows a prior-art O(5N) March test procedure to test the memory array RAM_8X4 102 shown in FIG. 1. Lines 1 to 2 are used to first fill the memory array with an all-0 background data. Line 3 is to cycle through the address word space from 0 to 7. Line 4 is to read from the memory word and to compare the result with the expected data pattern. Line 5 is to write the inverse pattern into the memory word. Line 6 is used to cycle through the address word space from 7 to 0. Line 7 is to read from the memory word and to compare the result with the expected data pattern. Line 8 is to write the inverse pattern into the memory word.

FIG. 9B shows an O(5N) adapted bit-wise March test procedure using a Johnson counter based sequence generator as a data generator to test the memory array RAM_8X4 102 shown in FIG. 1. Lines 1 to 2 are used to first fill the memory with an initial background data. Line 3 is to cycle through the address word space from 0 to 7. Line 4 is to cycle through the bit width from 0 to 3. Line 5 is to read from the memory word and to compare the result with the expected data pattern. Line 6 is to write a new pattern into the memory word. Line 7 is used to cycle through the address word space from 7 to 0. Line 8 is to cycle through the bit width from 0 to 3. Line 9 is to read from the ' memory word and to compare the result with the expected data pattern. Line 10 is to write a new pattern into the memory word.

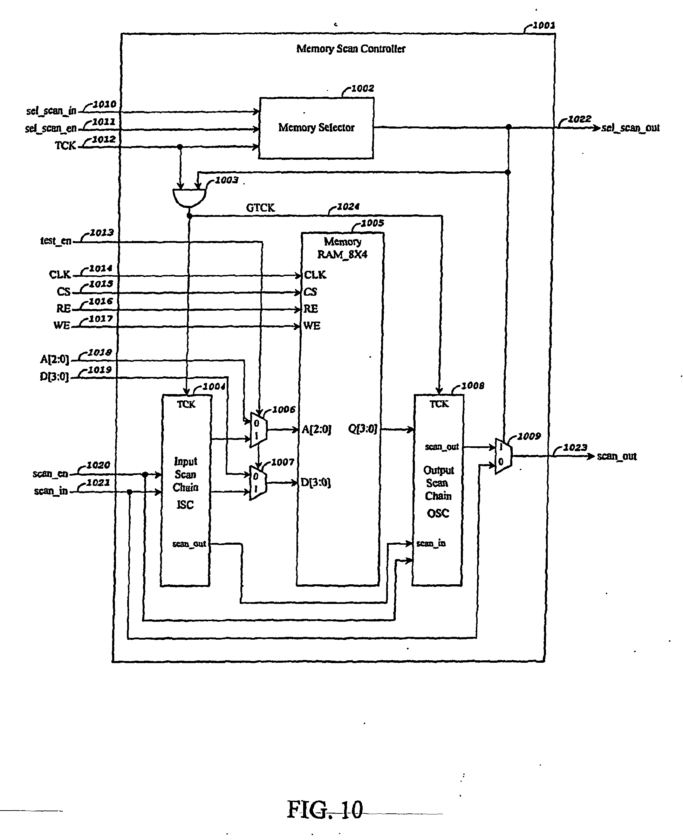

FIG. 10 shows an example memory scan controller to test or diagnose an 8-by-4 memory in accordance with the present invention.

The memory scan controller 1001 comprises one memory selector 1002, one AND gate 1003, one input scan chain ISC 1004, one output scan chain OSC 1008, and a plurality of multilplexers 1006, 1007, and 1009. The memory selector 1002 is a shift register whose input is sel scan_in 1010 and whose output is sel_scan out 1022. The shift enable signal of the memory selector 1002 is sel_scan_en 1011. TCK 1012 is the clock of the memory selector 1002. The memory address and data can be shifted in through the input scan chain ISC 1004. If scan_en 1020 is set to logic value 1, the memory address and data can be shifted into the input scan chain ISC 1004 through the scan chain input scan_in 1021. The data outputs of the memory RAM_8X4 1005 can be captured by the output scan chain OSC 1008. When test_en 1013 is set to logic value 1, the memory address and data of RAM_8X4 1005 are from ISC 1004; otherwise, the memory address and data of RAM_8X4 1005 are from normal addresses A[2:0] 1018 and data D[3:0] 1019 . The clock GTCK 1024 of ISC 1004 and OSC 1008 are from the AND gate 1003. If the memory selector 1002 is selected, sel_scan_out 1022 will be set to logic value 1 and GTCK 1024 will become the same as TCK 1012; otherwise GTCK 1027 is always logic value 0 because sel_scan_out 1022 is fixed at logic value 0.

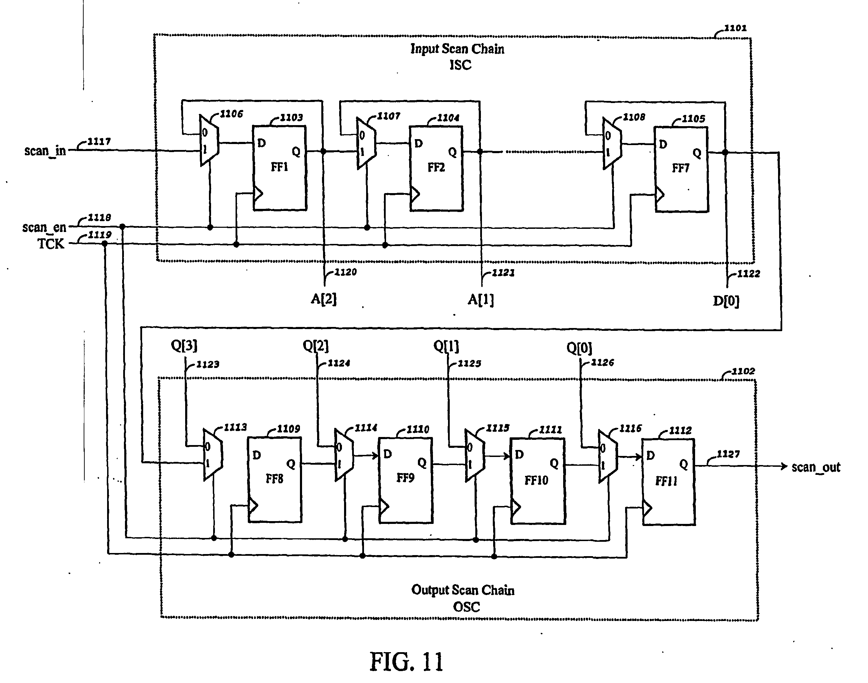

FIG. 11 shows an example scan status chain comprising the input scan chain and output scan chain in accordance with the present invention.

The input scan chain ISC 1101 is inserted for address lines A[2:0] and data inputs D[3:0] as shown in FIG. 10; while the output scan chain OSC 1102 is inserted for data outputs Q[3:0]. These two scan chains are connected together into a scan status chain 1100 from the input scan chain ISC 1101 to the output scan chain OSC 1102. The scan status chain 1100 has a scan input scan_in 1117 and a scan output scan_out 1127. Its scan enable signal is scan en 1118, and its clock is TCK 1119. Obviously, memory addresses, data to be written into a memory word, and data read out of a memory word can be transferred via this scan chain to conduct the memory scan test of a memory array.

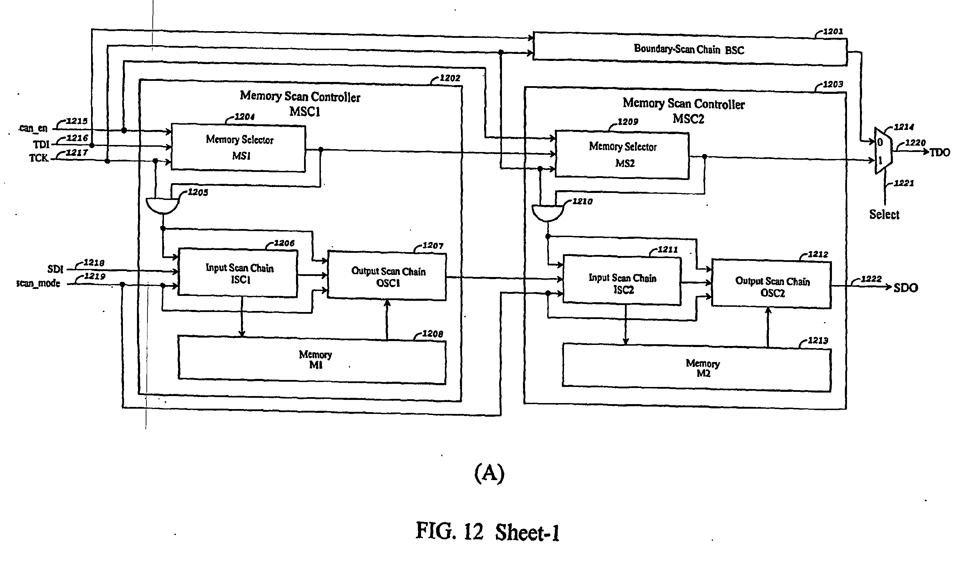

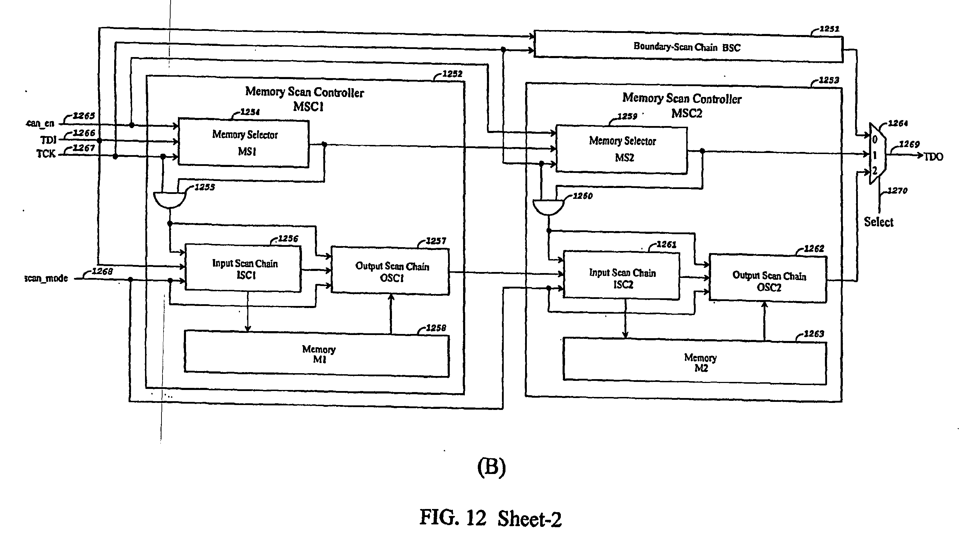

FIG. 12 shows two example scan connectors in a hierarchical memory scan controller to test or diagnose a plurality of memories using two memory scan controllers.

FIG. 12A shows a first example scan 1200. Memory scan controllers MSC1 1202 and MSC2 1203 contain memory selectors MS1 1204 and MS2 1209, AND gates 1205 and 1210, input scan chains ISC1 1206 and ISC2 1211, and output scan chains OSC1 1207 and OSC2 1212, respectively. Memory scan controllers MSC1 1202 and MSC2 1203 are used to control memory scan test for memory arrays M1 1208 and M2 1213, respectively. Memory selectors MS1 1204 and MS2 1209 form a scan chain from TDI 1216 to TDO 1220, which is operated by clock TCK 1217. The scan enable signal for this scan chain is scan_en 1215. In addition, ISC1 1206, OSC1 1207, ISC2 1211, and OSC2 1212 form a scan chain from SDI 1218 to SDO 1222. The scan enable signal for this scan chain is scan_mode 1219. The shift operation of ISC1 1206 and OSC1 1207 is controlled by a gated clock generated by combining TCK 1217 and the output of memory selector MS1 1204 with an AND gate 1205. As a result, only when memory array M1 1208 is selected for test or diagnosis, ISC1 1206 and OSC1 1207 can conduct a shift operation. Similarly, the shift operation of ISC2 1211 and OSC2 1212 is controlled by a gated clock generated by combining TCK 1217 and the output of memory selector MS2 1209 with an AND gate 1210. As a result, only when memory array M2 1213 is selected for test or diagnosis, ISC2 1211 and OSC2 1212 can conduct a shift operation.

FIG. 12B shows a second example scan 1250. Memory scan controllers MSC1 1252 and MSC2 1253 contain memory selectors MS1 1254 and MS2 1259, AND gates 1255 and 1260, input scan chains ISC1 1256 and ISC2 1261, and output scan chains OSC1 1257- and OSC2 1262, respectively. Memory scan controllers MSC1 1252 and MSC2 1253 are used to control memory scan test for memory arrays M1 1258 and M2 1263, respectively. Memory selectors MS1 1254 and MS2 1259 form a scan chain from TDI 1266 to TDO 1269, which is operated by clock TCK 1267. The scan enable signal for this scan chain is scan_en 1265. In addition, ISC1 1256, OSC1 1257, ISC2 1261, and OSC2 1262 also form a scan chain from TDI 1266 to TDO 1269. The scan enable signal for this scan chain is scan_mode 1268. The shift operation of ISC1 1256 and OSC1 1257 is controlled by a gated clock generated by combining TCK 1267 and the output of memory selector MS1 1254 with an AND gate 1255. As a result, only when memory array M1 1258 is selected for test or diagnosis, ISC1 1256 and OSC1 1257 can conduct a shift operation. Similarly, the shift operation of ISC2 1261 and OSC2 1262 is controlled by a gated clock generated by combining TCK 1267 and the output of memory selector MS2 1259 with an AND gate 1260. As a result, only when memory array M2 1263 is selected for test or diagnosis, ISC2 1261 and OSC2 1262 can conduct a shift operation.

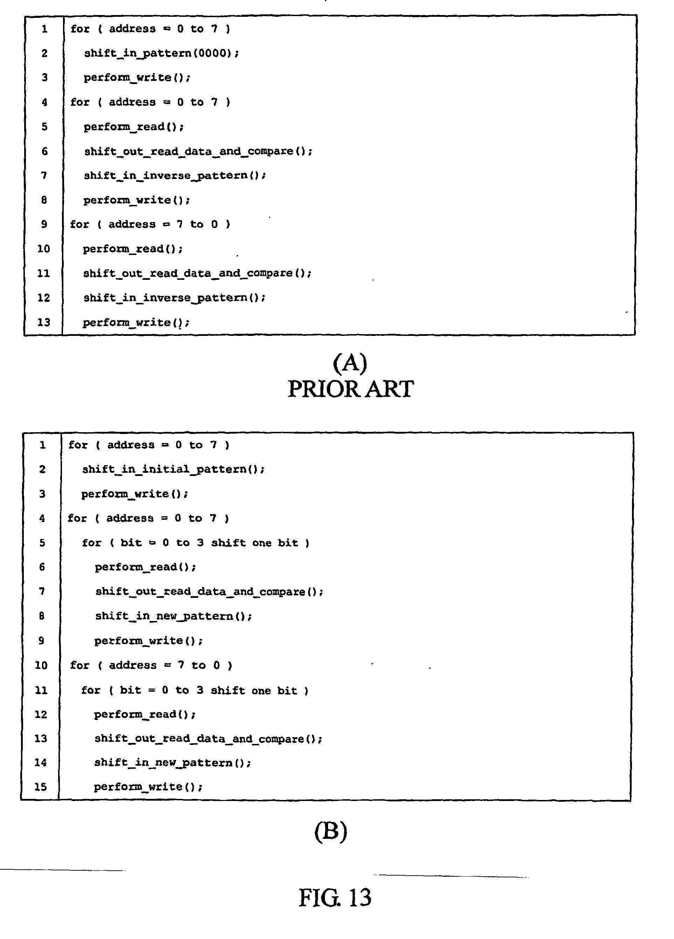

FIG. 13 shows a prior-art O(5N) March test procedure and an 0(5N) adapted bit-wise March test procedure of one embodiment of the present invention using memory scan to test or diagnose the memory of FIG. 10.

FIG. 13A shows a prior-art O(5N) March test procedure to test the memory array shown in FIG. 10. At the beginning, all words in the memory array are filled with an all-0 background data as shown on lines 1 to 3. Then, a test cycle is performed on each memory word in an increasing order from address 0 to address 7 as shown on lines 4 to 8. In each test cycle, the memory word is read and shifted out to compare with the expected data pattern as shown on lines 5 and 6. After that, the inversed data pattern is shifted in and written to the word as shown on lines 7 and 8. Such a test cycle is then repeated for each memory word in an decreasing order from address 7 to address 0 as shown on lines 9 to 13.

FIG. 13B shows an O(5N) adapted bit-wise March test procedure to test the memory array shown in FIG. 10. At the beginning, all words in the memory array are filled with an all-0 background data as shown on lines 1 to 3. Then, a test cycle is performed on each memory word in an increasing order from address 0 to address 7 as shown on lines 4 to 9. In each test cycle, the following set of operations are repeated on each memory word for 4 (the number of bits in a memory word) times as shown on lines 5 to 9: First, the memory word is read and shifted out to compare with the expected data pattern as shown on lines 6 and 7. After that, a new data pattern is shifted in and written to the word as shown on lines 8 and 9. Such a test cycle is then repeated for each memory word in an decreasing order from address 7 to address 0 as shown on lines 10 to 15.

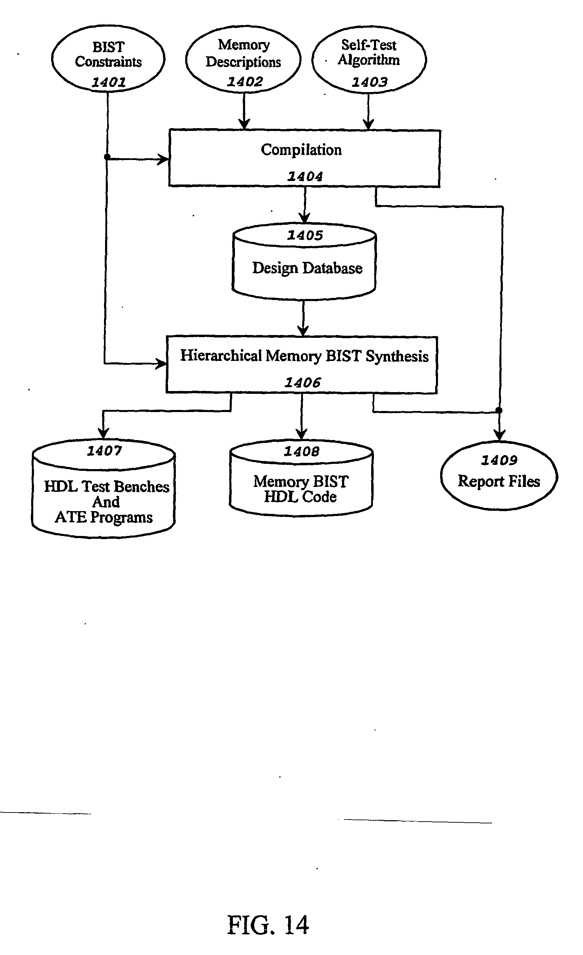

FIG. 14 shows a flow diagram of a computer-aided design (CAD) system for synthesizing a hierarchical memory BIST controller in accordance with the present invention. The CAD system accepts memory BIST constraints 1401, memory descriptions 1402, and a selected memory self-test algorithm 1403. Compilation 1404 is conducted to generate a design database 1405, based on which hierarchical memory BIST synthesis is performed to generate the memory BIST controller HDL (hardware design language) code 1408 as well as HDL test benches and ATE test programs 1407. All reports and errors are stored in the report files 1409.

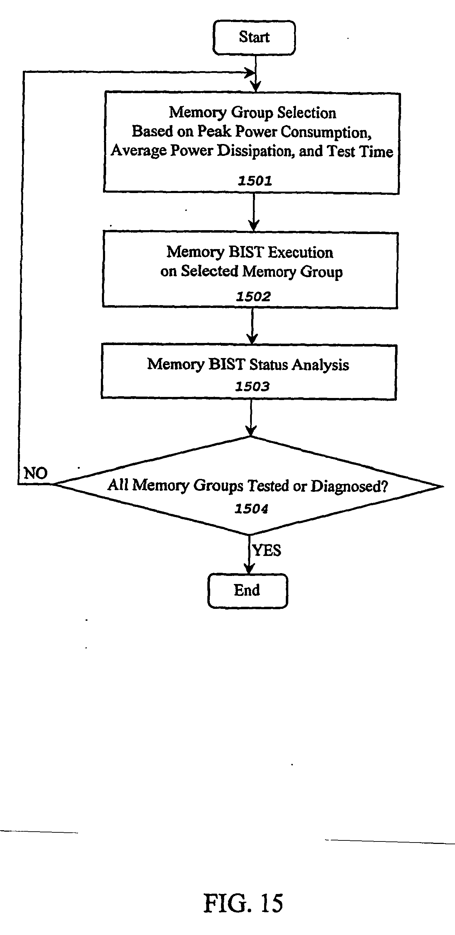

FIG. 15 shows a flow diagram of a memory BIST method to test or diagnose a plurality of memories in accordance with the present invention. First, in the stage of memory group selection 1501, a group of memory arrays is selected based on peak power consumption, average power dissipation, and test time. Second, in the stage of memory BIST execution 1502, the selected memory arrays are tested or diagnosed by the memory BIST technique. Third, in memory . BIST status analysis 1503, test or diagnosis status information is analyzed to determine whether a memory array is faulty or where the faulty words, etc. are located. This process is repeated until all memory groups are tested or diagnosed.

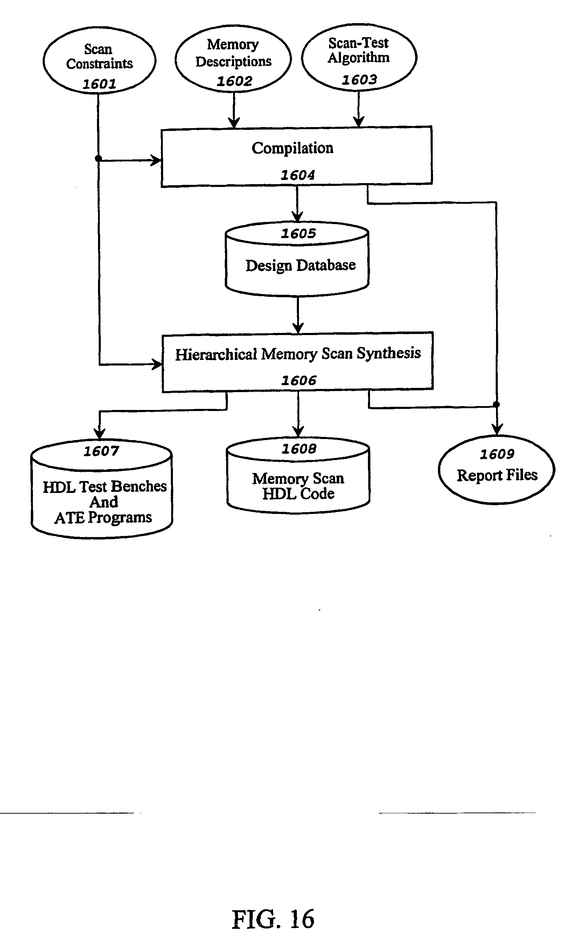

FIG. 16 shows a flow diagram of a computer-aided design (CAD) system for synthesizing a hierarchical memory scan controller in accordance with the present invention. The CAD system accepts memory scan constraints 1601, memory descriptions 1602, and a selected memory scan-test algorithm 1603. Compilation 1604 is conducted to generate a design database 1605, based on which hierarchical memory scan synthesis is performed to generate the memory scan controller HDL (hardware design language) code 1608 as well as HDL test benches and ATE test programs 1607. All reports and errors are stored in the report files 1609.

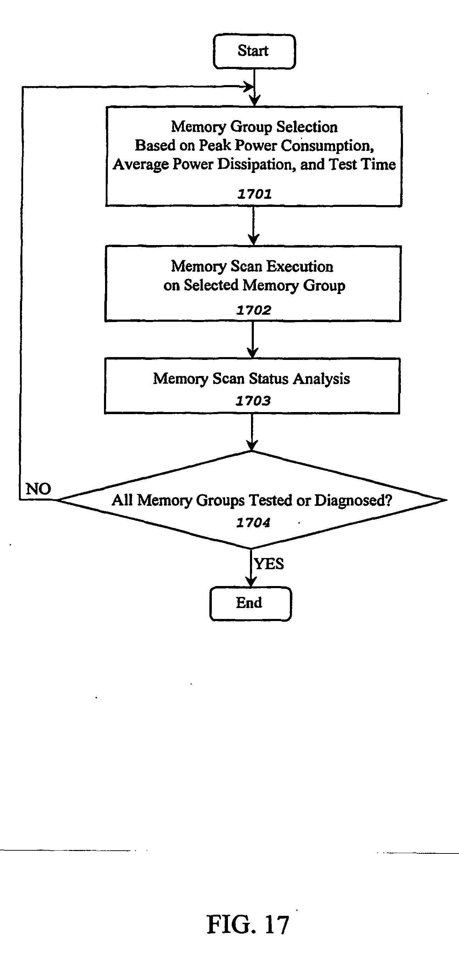

FIG. 17 shows a flow diagram of a memory scan method to test or diagnose a plurality of memories in accordance with the present invention. First, in the stage of memory group selection 1701, a group of memory arrays is selected based on peak power consumption, average power dissipation, and test time. Second, in the stage of memory scan execution 1702, the selected memory arrays are tested or diagnosed by the memory scan technique. Third, in memory scan status analysis 1703, test or diagnosis status information is analyzed to determine whether a memory array is faulty or where the faulty words, etc. are located. This process is repeated until all memory groups are tested or diagnosed.

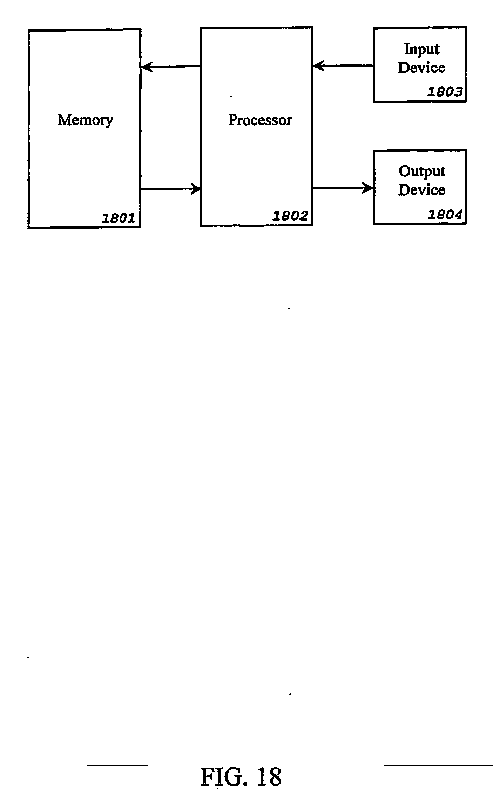

FIG. 18 shows an example system in which a computer-aided design (CAD) system using memory BIST or memory scan for testing or diagnosing a plurality of memory arrays, in accordance with the present invention, may be implemented. The system 1800 includes a processor 1802, which operates together with a memory 1801 to run a set of memory BIST or memory scan synthesis software. The processor 1802 may represent a central processing unit of a personal computer, workstation, mainframe computer, or other suitable digital processing device. The memory 1801 can be an electronic memory or a magnetic or optical disk-based memory, or various combinations thereof. A designer interacts with the memory BIST or memory scan synthesis software run by processor 1802 to provide appropriate inputs via an input device 1803, which may be a keyboard, disk drive, or other suitable source of design information. The processor 1802 provides outputs to the designer via an output device 1804, which may be a display, a printer, a disk drive, or various combinations of these and other elements. Having thus described presently preferred embodiments of the present invention, it can now be appreciated that the objectives of the invention have been fully achieved. And it will be understood by those skilled in the art that many changes in construction & circuitry, and widely differing embodiments & applications of the invention will suggest themselves without departing from the scope of the present invention. The disclosures and the description herein are intended to be illustrative and are not in any sense limitation of the invention, more preferably defined in scope by the following claims:

## Claims

1. A memory BIST (built-in self-test) controller (101) for testing or diagnosing a memory in an integrated circuit, the BIST controller having a data generator (106), the memory having a plurality of address lines and data inputs; said data generator **characterized by**:
(a) a sequence generator (202) for generating a sequence of patterns, wherein said sequence of patterns contains 4 distinct states, 00, 01, 10, and 11, between any two outputs of said sequence generator; and
(b) a data connector (202) for connecting the outputs of said sequence generator to said data inputs of said memory in response to a memory BIST mode so that all of the four combinations of 00, 01, 10 and 11 will be written into every two bits in every memory word.

2. The memory BIST of claim 1, further **characterized in that** said sequence generator (201) is a Johnson counter.

3. The memory BIST of claim 1, further **characterized in that** said sequence generator (201) includes an initialization circuitry for initializing said sequence generator to an initial state; wherein said initialization circuitry is controlled by said memory BIST mode.

4. The memory BIST of claim 1, further **characterized in that** said sequence generator includes a hold-state circuitry (227) for holding said sequence generator at its previous state; wherein said hold-state circuitry is controlled by said memory BIST mode.

5. The memory BIST of claim 1, further **characterized in that** said data connector (202) includes a plurality of multiplexers (215-218) for connecting said outputs of said sequence generator to said data inputs of said memory; wherein said multiplexers are controlled by said memory BIST mode.

6. The memory BIST defined in claim 1 further **characterised, by** a controller, said controller including:
(a) a finite-state machine (103) for generating control signals according to an adapted bit-wise test being performed on said memory to control the memory BIST operation, in response to a memory BIST mode;
(b) an address generator (105) controlled by said finite-state machine for generating the address of said memory; and
(c) a comparator (107) controlled by said finite-state machine for comparing comparison data with output data read from said memory.

7. The memory BIST of claim 6, further **characterized in that** said adapted bit-wise test being performed on said memory is a selected March-type memory self-test algorithm adapted to test coupling faults between any two bits in any memory word in said memory.

8. The memory BIST of claim 6, further **characterized in that** said sequence generator (201) is a Johnson counter.

9. The memory BIST of claim 6, further **characterized in that** said sequence generator (201) includes an initialization circuitry for initializing said sequence generator to an initial state; wherein said initialization circuitry is controlled by said memory BIST mode.

10. The memory BIST of claim 6, further **characterized in that** said sequence generator (201) includes a hold-state circuitry for holding said sequence generator at its previous state; wherein said hold-state circuitry is controlled by said memory BIST mode.

11. The memory BIST of claim 6, further **characterized in that** said data connector (202) include a plurality of multiplexers for connecting said outputs of said sequence generator to said data inputs of said memory; wherein said multiplexers are controlled by said memory BIST mode.

12. The memory BIST of claim 6, further **characterized in that** said memory further comprises a plurality of memory arrays to be tested or diagnosed simultaneously.

13. The memory BIST of claim 1 further **characterized by** a memory scan controller (1001), said memory scan controller comprising:
(a) a plurality of scan cells coupled together as a shift register for shifting in a sequence of patterns to said address lines and said data inputs, in response to a memory scan model and
(b) an external automatic test equipment (ATE) for generating and shifting in said sequence of patterns to said address lines and said data inputs according to an adapted bit-wise rest being performed an said memory in response to said memory scan mode.

14. The memory BIST of claim 13, further **characterized in that** said external automatic test equipment (ATE) further comprises shifting out output data read from said memory to said ATE and comparing said output data with expected data stored in said ATE.

15. The memory BIST of claim 13, further **characterized in that** said adapted bit-wise test being performed on said memory is a selected March-type memory scan-test algorithm adapted to test coupling faults between any two bite in any memory word in said memory.

16. the memory BIST of claim 13, further **characterized in that** said sequence of patterns in said data inputs is generated in accordance with tho operation of a Johnson counter.

## Patentansprüche

1. Ein Speicher-Selbstüberprüfungs-(BIST (built-in self-test))-Steuergerät (101) zum Prüfen oder Diagnostizieren eines Speichers in einer integrierten Schaltung, wobei das BIST-Steuergerät einen Datenerzeuger (106) hat, der Speicher eine Mehrzahl von Adreßleitungen und Dateneingängen hat; wobei besagter Datenerzeuger **gekennzeichnet ist durch**
(a) einen Folgenerzeuger (201) zum Erzeugen einer Folge von Mustern, worin besagte Folge von Mustern vier unterschiedene Zustände enthält, 00, 01, 10 und 11, zwischen jeglichen zwei Ausgängen besagten Folgenerzeugers; und
(b) einen Datenverbinder (202) zum Verbinden der Ausgänge besagten Folgenerzeugers an besagte Dateneingänge besagten Speichers in Antwort auf einen Speicher-BIST-Modus, so daß alle der vier Kombinationen von 00, 01, 10 und 11 1 in jede zwei Bits in jedem Speicherwort geschrieben werden.

2. Das Speicher-BIST des Anspruchs 1, weiter **gekennzeichnet dadurch, daß** besagter Folgenerzeuger (201) ein Johnson-Zähler ist.

3. Das Speicher-BIST des Anspruchs 1, weiter **gekennzeichnet dadurch, daß** besagter Folgenerzeuger (201) eine Initialisierungsschaltung zum Initialisieren besagten Folgenerzeugers in einen Anfangszustand aufweist, wobei besagte Initialisierungsschaltung durch besagten Speicher-BIST-Modus gesteuert wird.

4. Das Speicher-BIST des Anspruchs 1, weiter **dadurch gekennzeichnet, daß** besagter Folgenerzeuger eine Haltezustands-Schaltung (227) zum Halten besagten Folgenerzeugers in seinem vorhergehenden Zustand aufweist, worin besagte Haltezustands-Schaltung durch besagten Speicher-BIST-Modus gesteuert wird.

5. Das Speicher-BIST des Anspruchs 1, weiter **gekennzeichnet dadurch, daß** besagter Datenverbinder (202) eine Mehrzahl von Multiplexern (215 - 218) zum Verbinden besagter Ausgänge besagten Folgenerzeugers an besagte Dateneingänge besagten Speichers aufweist, worin besagte Multiplexer durch besagten Speicher-BIST-Modus gesteuert werden.

6. Das in Anspruch 1 angegebene Speicher-BIST, weiter **gekennzeichnet durch** ein Steuergerät, wobei besagtes Steuergerät aufweist:
(a) einen endlichen Automaten (103) zum Erzeugen von Steuersignalen entsprechend einer angepaßten bitweisen Prüfung, die an besagtem Speicher durchgeführt wird, um den Speicher-BIST-Betrieb zu steuern, in Antwort auf einen Speicher-BIST-Modus;
(b) einen Adressenerzeuger (105), der **durch** besagten endlichen Automaten gesteuert wird um die Adresse besagten Speichers zu erzeugen; und
(c) einen Vergleicher (107), der **durch** besagten endlichen-Automaten gesteuert wird um Vergleichsdaten mit Ausgangsdaten, die aus besagtem Speicher gelesen werden, zu vergleichen.

7. Das Speicher-BIST des Anspruchs 6, weiter **dadurch gekennzeichnet, daß** besagte angepaßte bitweise Prüfung, die an besagtem Speicher durchgeführt wird, ein ausgewählter March-artiger Speicherselbstüberprüfungsalgorithmus ist, daran angepaßt, Verbindungsfehler zwischen jeglichen zwei Bits in jeglichem Speicherwort in besagtem Speicher zu prüfen.

8. Das Speicher-BIST des Anspruchs 6, weiter **gekennzeichnet dadurch, daß** besagter Folgenerzeuger (201) ein Johnson-Zähler ist.

9. Das Speicher-BIST des Anspruchs 6, weiter **gekennzeichnet dadurch, daß** besagter Folgenerzeuger (201) eine Initialisierungsschaltung zum Initialisieren besagten Folgenerzeugers in einen Anfangszustand aufweist, worin besagte Initialisierungsschaltung durch besagten Speicher-BIST-Modus gesteuert wird.

10. Das Speicher-BIST des Anspruchs 6, weiter **dadurch gekennzeichnet, daß** besagter Folgenerzeuger (201) eine Haltezustands-Schaltung zum Halten besagten Folgenerzeugers in seinem vorhergehenden Zustand aufweist, worin besagte Haltezustands-Schaltung durch besagten Speicher-BIST-Modus gesteuert wird.

11. Das Speicher-BIST des Anspruchs 6, weiter **gekennzeichnet dadurch, daß** besagter Datenverbinder (202) eine Mehrzahl von Multiplexern zum Verbinden besagter Ausgänge besagten Folgenerzeugers an besagte Dateneingänge besagten Speichers aufweist, worin besagte Multiplexer durch besagten Speicher-BIST-Modus gesteuert werden.

12. Das Speicher-BIST des Anspruchs 6, weiter **gekennzeichnet dadurch, daß** besagter Speicher weiter eine Mehrzahl von Speicherbereichen, die gleichzeitig getestet oder diagnostiziert werden, aufweist

13. Das Speicher-BIST des Anspruchs 1, weiter **gekennzeichnet durch** ein Speicherabtaststeuergerät, wobei besagtes Speicherabtaststeuergerät aufweist:
(a) Eine Mehrzahl von Abtastzellen, die als ein Schieberegister zusammengeschaltet sind, um eine Folge von Mustern an besagte Adreßleitungen und besagte Dateneingänge einzuschieben, in Antwort auf einen Speicherabtastmodus, und
(b)eine externe automatische Prüfausrüstung (ATE (external automatic test equipment)) zum Erzeugen und Einschieben besagter Folge von Mustern an besagte Adreßleitungen und besagte Dateneingänge gemäß einer angepaßten bitweisen Prüfung, die an besagtem Speicher in Antwort auf besagten Speicherabtastmodus durchgeführt wird.

14. Das Speicher-BIST des Anspruchs 13, weiter **gekennzeichnet dadurch**, das besagte externe automatische Prüfeinrichtung (ATE) weiter aufweist das Ausschieben von Ausgangsdaten, die aus besagtem Speicher gelesen sind an besagte ATE und das Vergleichen besagter Ausgangsdaten mit erwarteten Daten, die in besagter ATE gespeichert sind.

15. Das Speicher-BIST des Anspruchs 13, weiter **dadurch gekennzeichnet, daß** besagte angepaßte bitweise Prüfung, die an besagtem Speicher durchgeführt wird, ein ausgewählter March-artiger Speicherabtastprüfungsalgortimus ist, der daran angepaßt ist, Verbindungsfehler zwischen jeglichen zwei Bits in jeglichem Speicherwort in besagtem Speicher zu prüfen.

16. Das Speicher-BIST des Anspruchs 13, weiter **gekennzeichnet dadurch, daß** besagte Folge von Mustern in besagten Dateneingängen gemäß der Betriebsweise eines Johnson-Zählers erzeugt wird.

## Revendications

1. Un contrôleur de mémoire BIST (« built-in self-test », autotest incorporé) (102) pour tester ou diagnostiquer une mémoire dans un circuit intégré, le contrôleur BIST comportant un générateur de données (106), la mémoire comportant une pluralité de lignes d'adresse et entrées de données, ledit générateur de données étant **caractérisé par**:
a) un générateur de séquence (201) pour générer une séquence de patrons, où ladite séquence de patrons contient 4 états différents, 00, 01, 10, et 11, entre deux sorties quelconques dudit générateur de séquence, et
b) un connecteur de données (202) pour connecter les sorties dudit générateur de séquence vers lesdites entrées de données de ladite mémoire en réponse à un mode de mémoire BIST de manière à ce que toutes les quatre combinaisons de 00, 01, 10 et 11 soient écrites dans chaque deux bits dans chaque mot de mémoire.

2. Le BIST de mémoire de la revendication 1, **caractérisé en outre en ce que** ledit générateur de séquence (201) est un compteur Johnson.

3. Le BIST de mémoire de la revendication 1, **caractérisé en outre en ce que** ledit générateur de séquence (201) inclut un ensemble de circuits d'initialisation pour initialiser ledit générateur de séquence à un état initial, où ledit ensemble de circuits d'initialisation est contrôlé par ledit mode de mémoire BIST.

4. Le BIST de mémoire de la revendication 1, **caractérisé en outre en ce que** ledit générateur de séquence inclut un ensemble de circuits de maintien (227) pour maintenir ledit générateur de séquence dans son état précédent, où ledit ensemble de circuits de maintien est contrôlé par ledit mode de mémoire BIST.

5. Le BIST de mémoire de la revendication 1, **caractérisé en outre en ce que** ledit connecteur de données (202) inclut une pluralité de multiplexeurs (215-218) pour connecter lesdites sorties dudit générateur de séquence aux dites entrées de données de ladite mémoire, où lesdits multiplexeurs sont contrôlés par ledit mode de mémoire BIST.

6. Le BIST de mémoire de la revendication 1, **caractérisé en outre par** un contrôleur, ledit contrôleur incluant :
a) une machine à états finis (103) pour générer des signaux de contrôle suivant un test adapté de manipulation de bits étant effectué sur ladite mémoire pour contrôler l'opération du BIST de mémoire, en réponse à un mode de mémoire BIST,
b) un générateur d'adresses (105) contrôlé par ladite machine à états finis pour générer l'adresse de ladite mémoire, et
c) un comparateur (107) contrôlé par ladite machine à états finis pour comparer de données de comparaison avec de données de sortie lues de ladite mémoire.

7. Le BIST de mémoire de la revendication 6, **caractérisé en outre en ce que** ledit test adapté de manipulation de bits étant effectué sur ladite mémoire est un algorithme sélectionné d'autotest de mémoire de type March adapté pour tester des fautes de couplage entre deux bits quelconque dans tout mot de mémoire dans ladite mémoire.

8. Le BIST de mémoire de la revendication 6, **caractérisé en outre en ce que** ledit générateur de séquence (201) est un compteur Johnson.

9. Le BIST de mémoire de la revendication 6, **caractérisé en outre en ce que** ledit générateur de séquence (201) inclut un ensemble de circuits d'initialisation pour initialiser ledit générateur de séquence à un état initial, où ledit ensemble de circuits d'initialisation est contrôlé par ledit mode de mémoire BIST,

10. Le BIST de mémoire de la revendication 6, **caractérisé en outre en ce que** ledit générateur de séquence inclut un ensemble de circuits de maintien (227) pour maintenir ledit générateur de séquence dans son état précédent, où ledit ensemble de circuits de maintien est contrôlé par ledit mode de mémoire BIST.

11. Le BIST de mémoire de la revendication 6, **caractérisé en outre en ce que** ledit connecteur de données (202) inclut une pluralité de multiplexeurs (215-218) pour connecter lesdites sorties dudit générateur de séquence aux dites entrées de données de ladite mémoire, où lesdits multiplexeurs sont contrôlés par ledit mode de mémoire BIST.

12. Le BIST de mémoire de la revendication 6, **caractérisé en outre en ce que** ladite mémoire comprend en outre une pluralité de matrices mémoire à être testées ou diagnostiquées simultanément.

13. Le BIST de mémoire de la revendication 1, **caractérisé en outre par** un contrôleur de balayage de mémoire (1001), ledit contrôleur de balayage de mémoire comprenant :
a) une pluralité de cellules de balayage couplées les unes aux autres comme registre à décalage pour relayer une séquence de patrons vers lesdites lignes d'adresse et lesdites entrées de données, en réponse à un mode de balayage de mémoire, et
b) un équipement de test automatique externe (ATE) pour générer et relayer ladite séquence de patrons vers lesdites lignes d'adresse et lesdites entrées de données suivant un test adapté de manipulation de bits étant effectué sur ladite mémoire en réponse au dit mode de balayage de mémoire.

14. Le BIST de mémoire de la revendication 13, **caractérisé en outre en ce que** ledit équipement de test automatique externe (ATE) comprend en outre le relais des données de sortie lues de ladite mémoire vers ledit ATE et la comparaison des dites données de sortie avec des données espérées stockées dans ledit ATE.

15. Le BIST de mémoire de la revendication 13, **caractérisé en outre en ce que** ledit test adapté de manipulation de bits étant effectué sur ladite mémoire est un algorithme sélectionné d'autotest de mémoire de type March adapté pour tester des fautes de couplage entre deux bits quelconque dans tout mot de mémoire dans ladite mémoire.

16. Le BIST de mémoire de la revendication 13, **caractérisé en outre en ce que** ladite séquence de patrons dans lesdites entrées de données est générée en accord avec l'opération d'un compteur Johnson.
